# EUROPEAN PATENT APPLICATION

(11) **EP 4 468 379 A1**
(43) Date of publication of application: **27.11.2024**
(21) Application number: 24177972.7
(22) Date of filing: 24.05.2024
(51) Int. Cl.: H01L 33/54, H01L 33/58, H01L 33/56

(54) **LIGHT EMITTING DEVICE AND APPARATUS USING THE SAME**

(30) Priority: 25.05.2023 US 202363468820 P; 23.05.2024 US 202418672306
(71) Applicant: Seoul Viosys Co., Ltd., Ansan-si, Gyeonggi-do 15429 (KR)
(72) Inventor: JEONG, Jae Hak, 15429 Ansan-si (KR); JANG, Bo Ram I, 15429 Ansan-si (KR)
(74) Representative: Stolmár & Partner Patentanwälte PartG mbB

(57) **Abstract**

A light emitting apparatus is disclosed. The light emitting apparatus includes a base substrate, at least a light emitting source disposed on the base substrate, and a multi-refractive layer refracting light emitted from the light emitting source, wherein the multi-refractive layer includes a first refractive layer and a second refractive layer disposed outside the first refractive layer, the first refractive layer having a lower index of refraction than the second refractive layer.

## Description

### [Technical Field]

The present disclosure relates to a light emitting device and an apparatus using the same.

### [Background Art]

Light emitting devices, for example, light emitting diodes, are inorganic semiconductor devices that emit light through recombination of electrons and holes, and have recently been used in various fields, for example, display devices, vehicular lamps, general lighting, and the like. Since light emitting diodes have long lifespan, low power consumption, and fast response time, light emitting apparatuses including the light emitting diodes are expected to replace conventional light sources.

Alight emitting device package may include two or more light emitting devices and allows adjustment in beam angle according to consumer requests. In addition, the light emitting device package requires a structure for directing light emitted from the light emitting devices in a desired direction as much as possible.

To this end, the light emitting device package may include a lens covering at least a region of the light emitting device. Light emitted from the light emitting device is distributed through the lens to realize uniform light over a large area.

In general, light emitted from the light emitting device has a relatively narrow beam angle, thereby limiting sufficient distribution of light through the lens. Moreover, since the light emitting device is disposed below the lens, there is a problem in that a portion of light emitted from the light emitting device fails to enter the lens and is easily lost below the lens.

### [Disclosure]

### [Technical Problem]

Embodiments of the present disclosure provide a light emitting device with high luminous efficacy and reduced defects, and an apparatus using the same.

Embodiments of the present disclosure provide a light emitting apparatus that secures structural stability through reduction in stress caused by external pressure.

Embodiments of the present disclosure provide a light emitting apparatus emitting a large quantity of light through increase in light extraction efficiency.

Embodiments of the present disclosure provide a light emitting apparatus that delays moisture permeation while improving reliability through increase in length of a moisture permeation path.

The problems to be solved by the present disclosure are not limited to the problems mentioned above, and other technical problems not mentioned will become apparent to a person having ordinary knowledge in the art from the following description.

### [Technical solution]

The present disclosure provides a light emitting device and an apparatus using the same.

A light emitting device according to an embodiment of the present disclosure, a light emitting apparatus includes: a base substrate; At least a light emitting source disposed on the base substrate; and a multi-refractive layer refracting light emitted from the light emitting source, wherein the multi-refractive layer includes a first refractive layer and a second refractive layer disposed outside the first refractive layer, and the first refractive layer has a lower index of refraction than the second refractive layer.

At least a refractive layer of the first refractive layer or the second refractive layer may have a planar shape in a region thereof.

At least a refractive layer of the multi-refractive layer may include a curvature in a region thereof. Further, the first refractive layer may include a first curvature region on one side region thereof and the second refractive layer may include a second curvature region having a curvature, wherein the second curvature region may have a greater radius of curvature than the first curvature region.

The first refractive layer may cover a side region of the light emitting source and may cover a region of the base substrate.

The second refractive layer may cover a region of the light emitting source and the first refractive layer may be disposed between the light emitting source and the second refractive layer. At least a refractive layer of the multi-refractive layer may include a rough region, i.e., a roughness shape in a region thereof.

At least a refractive layer of the multi-refractive layer may include a spacer having a predetermined thickness and the spacer may include a stress reduction region having a curvature in at least a region thereof.

The base substrate or the multi-refractive layer may be provided on one region thereof with a stereobate to absorb or reflect light emitted from the at least a light emitting source towards the base substrate or a side region of the light emitting source so as to be directed towards the multi-refractive layer.

The multi-refractive layer may further include at least a refractive layer composed of a gas or liquid between the first refractive layer and the second refractive layer.

The first refractive layer may have a lower index of refraction than the at least a light emitting source.

A region of the first refractive layer may adjoin a region of the light emitting source.

The plurality of refractive layers may have different radii of curvature.

The first refractive layer may have a first radius of curvature and the second refractive layer may have a second radius of curvature, wherein the first radius of curvature may be less than the second radius of curvature.

The fourth refractive layer may have higher hardness than the third refractive layer.

An outermost refractive layer may have higher hardness than a refractive layer adjacent thereto.

A maximum height of the second refractive layer from the light emitting device may be greater than a height of the first refractive layer.

The light emitting apparatus may include a display device that displays an image using light emitted from the light emitting source.

Exemplary embodiments provide a light emitting apparatus including a multi-refractive layer to improve luminous efficiency, a light emitting apparatus includes a base substrate; at least a light emitting source disposed on the base substrate; and a multi-refractive layer including a plurality of refractive layers refracting at least a fraction of light emitted from the at least a light emitting source, wherein the multi-refractive layer includes a first refractive layer and a second refractive layer disposed on the first refractive layer, so that the second refractive layer is located on a side of the first refractive layer opposite to the light emitting source, and the first refractive layer and the second refractive layer may include materials having different indices of refraction in at least regions thereof.

At least a refractive layer of the first refractive layer or the second refractive layer may include at least a curvature region.

The first refractive layer may have a greater curvature than the second refractive layer.

At least a refractive layer of the first refractive layer or the second refractive layer may include one or more straight regions.

At least a refractive layer of the first refractive layer or the second refractive layer may include a roughness region.

An outermost refractive layer of the multi-refractive layer may have higher hardness than a refractive layer adjacent thereto.

At least a refractive layer of the multi-refractive layer may include a spacer having a predetermined thickness and the spacer may include a stress reduction region having a curvature in at least a region thereof.

The base substrate or the multi-refractive layer may be provided on a region thereof with a stereobate to reflect or absorb light emitted from the at least a light emitting source towards the base substrate or a side region of the light emitting source so as to be directed towards the multi-refractive layer.

The multi-refractive layer may further include at least a refractive layer composed of a gas or liquid between the first refractive layer and the second refractive layer.

The first refractive layer may have a lower index of refraction than the at least a light emitting source.

A region of the first refractive layer may adjoin a region of the at least a light emitting source.

At least a portion of the multi-refractive layer may be composed of a gas or a liquid.

The light emitting apparatus may include a display device that displays an image using light emitted from the light emitting source.

According to one or more embodiments of the present disclosure, a light emitting apparatus includes: a base substrate; at least a light emitting source disposed on the base substrate; and a multi-refractive layer including a plurality of refractive layers refracting at least a fraction of light emitted from the at least a light emitting source, wherein the multi-refractive layer includes m layers (m being a natural number greater than or equal to 3), an n^{th} refractive layer corresponding to an n^{th} layer of the multi-refractive layer (n being greater than 1 and less than m) and having an index of refraction RIₙ, an n-1^{th} refractive layer corresponding to an n-1^{th} layer of the multi-refractive layer and having an index of refraction RIₙ₋₁, and an n+1^{th} refractive layer corresponding to an n+1^{th} layer of the multi-refractive layer and having an index of refraction RIₙ₊₁; and the index of refraction RIₙ is greater than the index of refraction RIₙ₋₁ and is greater than the index of refraction RIₙ₊₁ for at least one n.

The last m^{th} refractive layer of the multi-refractive layer may have an index of refraction RIₘ, where RIₘ is greater than an index of refraction of external air.

At least a refractive layer of the first refractive layer or the second refractive layer may include at least a curvature region.

A curvature region of the first refractive layer may have a greater curvature than a curvature region of the second refractive layer.

At least a refractive layer of the first refractive layer or the second refractive layer may include a straight region.

An outermost refractive layer of the multi-refractive layer may have higher hardness than a refractive layer adjacent thereto.

At least a refractive layer of the multi-refractive layer may include a roughness region.

At least a refractive layer of the multi-refractive layer may include a spacer having a predetermined thickness and the spacer may include a stress reduction region having a curvature in at least a region thereof.

The base substrate or the multi-refractive layer may be provided on a region thereof with a stereobate to reflect or absorb light emitted from the at least a light emitting source towards the base substrate or a side region of the light emitting source so as to be directed towards the multi-refractive layer.

The multi-refractive layer may further include at least a refractive layer composed of a gas or liquid between the first refractive layer and the second refractive layer.

The first refractive layer may have a lower index of refraction than the at least a light emitting source.

A region of the first refractive layer may adjoin a region of the at least a light emitting source.

The light emitting apparatus may include a display device that displays an image using light emitted from the light emitting source.

According to one or more embodiments of the present disclosure, a light emitting apparatus includes: a base substrate; at least a light emitting source disposed on the base substrate; and a multi-refractive layer including a plurality of refractive layers refracting at least a fraction of light emitted from the at least a light emitting source, the plurality of refractive layers including: a first refractive layer disposed in at least a region of the light emitting source; a second refractive layer disposed on an upper region of the first refractive layer; a third refractive layer disposed in a region of the second refractive layer and in a region of the base substrate; and a fourth refractive layer disposed in an outermost region of the multi-refractive layer, wherein the third refractive layer adjoins the first refractive layer and the second refractive layer in at least a region thereof and the third refractive layer has a lower index of refraction than the second refractive layer.

The index of refraction of the third refractive layer may be less than or equal to an index of refraction of the first refractive layer.

The plurality of refractive layers may have different radii of curvature.

At least a refractive layer of the first refractive layer or the second refractive layer may include at least a curvature region.

A curvature region of the first refractive layer may have a greater curvature than a curvature region of the second refractive layer.

At least a refractive layer of the first refractive layer or the second refractive layer may include one or more straight regions.

At least a refractive layer of the first refractive layer or the second refractive layer may include a roughness region.

An outermost refractive layer of the multi-refractive layer may have higher hardness than a refractive layer adjacent thereto.

At least a refractive layer of the multi-refractive layer may include a spacer having a predetermined thickness and the spacer may include a stress reduction region having a curvature in at least a region thereof.

The base substrate or the multi-refractive layer may be provided on a region thereof with a stereobate to reflect or absorb light emitted from the at least a light emitting source towards the base substrate or a side region of the light emitting source so as to be directed towards the multi-refractive layer.

The multi-refractive layer may further include at least a refractive layer composed of a gas or liquid between the first refractive layer and the second refractive layer.

The first refractive layer may have a lower index of refraction than the at least a light emitting source.

A region of the first refractive layer may adjoin a region of the at least a light emitting source.

At least a portion of the multi-refractive layer may be composed of a gas or a liquid.

The light emitting apparatus may include a display device that displays an image using light emitted from the light emitting source.

The plurality of refractive layers may have curvatures gradually decreasing outwards from the light emitting source.

The multi-refractive layer may include an overlapping region of the first refractive layer, the second refractive layer, the third refractive layer, and the fourth refractive layer in a direction perpendicular to the base substrate and the curvature of the multi-refractive layer may be reduced with increasing distance from the base substrate with respect to the perpendicular direction.

The multi-refractive layer may include a stacked region in which at least three of the first refractive layer, the second refractive layer, the third refractive layer, or the fourth refractive layer are stacked in a direction horizontal to the base substrate.

In a light emitting device according to another embodiment of the present disclosure, a light emitting module includes: a module substrate; at least a light emitting source disposed on the module substrate; and a multi-refractive layer refracting at least a fraction of light emitted from the at least a light emitting source, wherein the multi-refractive layer includes a first refractive layer and a second refractive layer disposed outside the first refractive layer, and the first refractive layer has a lower index of refraction than the second refractive layer.

At least a refractive layer of the multi-refractive layer may include a spacer including a region parallel to at least a region of the module substrate and having a predetermined thickness.

The module substrate and the multi-refractive layer may include a stereobate formed on at least a region of the module substrate or the multi-refractive layer.

at least a refractive layer of the first refractive layer or the second refractive layer may include a roughness region.

The first refractive layer may have a lower index of refraction than the at least a light emitting source.

A region of the first refractive layer may adjoin a region of the light emitting source.

At least a layer of the multi-refractive layer may be composed of a gas.

The light emitting module may include a display device that displays an image using light emitted from the light emitting source.

The above aspects of the present disclosure are only some of exemplary embodiments of the present disclosure and various embodiments reflecting technical features of the present disclosure may be derived and understood by a person having ordinary knowledge in the art from the following detailed description of the present disclosure.

### [Advantageous Effects]

Exemplary embodiments of the present disclosure provide a light emitting apparatus that secures structural stability through reduction in stress caused by external pressure.

Exemplary embodiments of the present disclosure provide a light emitting apparatus that can increase light output through increase in light extraction efficiency.

Exemplary embodiments of the present disclosure provide a light emitting apparatus that delays moisture permeation while improving reliability through increase in length of a moisture permeation path.

Advantageous effects to be obtained from the present disclosure are not limited to those mentioned above and other effects not mentioned herein will become apparent to a person having ordinary knowledge in the art.

### [Description of Drawings]

The accompanying drawings, which are included to provide a further understanding of the present disclosure, illustrate embodiments of the present disclosure and serve to explain the principles of the present disclosure together with the detailed description.
FIG. 1 is cross-sectional views of light emitting apparatuses 10a, 10b according to embodiments of the present disclosure.
FIG. 2 is a cross-sectional view of a light emitting apparatus 20 according to an embodiment of the present disclosure.
FIG. 3 is a cross-sectional view of a light emitting apparatus 30 according to an embodiment of the present disclosure.
FIG. 4 is a cross-sectional view of a light emitting apparatus 40 according to an embodiment of the present disclosure.
FIG. 5 is views of a stress reduction region 508 of a light emitting apparatus 50 according to an embodiment of the present disclosure.
FIG. 6 is a cross-sectional view of a light emitting apparatus 60 according to an embodiment of the present disclosure.
FIG. 7 is exemplary views of various shapes of a multi-refractive layer according to embodiments of the present disclosure.
FIG. 8 is a view of a light emitting module 1000 including a light emitting apparatus according to an embodiment of the present disclosure.

### [Detailed Description]

The present disclosure may be variously modified and realized in many different forms, and thus specific embodiments will be exemplified in the drawings and described in detail herein below. However, in the following description, for the purposes of explanation, numerous specific details are set forth in order to provide thorough understanding of various exemplary embodiments or implementations of the present disclosure. As used herein, "embodiments" and "implementations" are interchangeable terms for non-limiting examples of devices or methods employing one or more of the inventive concepts disclosed herein. It will be apparent, however, that various exemplary embodiments may be practiced without these specific details or with one or more equivalent arrangements. In other instances, well-known structures and devices are shown in block diagram form in order to avoid unnecessarily obscuring various exemplary embodiments. Further, various exemplary embodiments may be different, but do not have to be exclusive. For example, specific shapes, configurations, and characteristics of an exemplary embodiment may be used or implemented in another exemplary embodiment without departing from the inventive concepts.

Unless otherwise specified, the illustrated exemplary embodiments are to be understood as providing exemplary features of varying detail of some ways in which the inventive concepts may be implemented in practice. Therefore, unless otherwise specified, the features, components, modules, layers, films, panels, regions, and/or aspects (hereinafter individually or collectively referred to as "elements") of the various embodiments may be otherwise combined, separated, interchanged, and/or rearranged without departing from the inventive concepts.

The use of cross-hatching and/or shading in the accompanying drawings is generally provided to clarify boundaries between adjacent elements. As such, neither the presence nor the absence of cross-hatching or shading conveys or indicates any preference or requirement for particular materials, material properties, dimensions, proportions, commonalities between illustrated elements, and/or any other characteristic, attribute, and property of the elements, unless specified. Further, in the accompanying drawings, the size and relative sizes of elements may be exaggerated for clarity and/or descriptive purposes. When an exemplary embodiment is implemented differently, a specific process order may be performed differently from the described order. For example, two consecutively described processes may be performed substantially at the same time or performed in an order opposite the described order. In addition, like reference numerals denote like elements.

When an element, such as a layer, is referred to as being "on," "connected to," or "coupled to" another element or layer, it may be directly on, connected to, or coupled to the other element or layer or intervening elements or layers may be present. When, however, an element or layer is referred to as being "directly on," "directly connected to," or "directly coupled to" another element or layer, there are no intervening elements or layers present. To this end, the term "connected" may refer to physical, electrical, and/or fluid connection, with or without intervening elements. Further, the DR1-axis, the DR2-axis, and the DR3-axis are not limited to three axes of a rectangular coordinate system, such as the x, y, and z-axes, and may be interpreted in a broader sense. For example, the DR1-axis, the DR2-axis, and the DR3-axis may be perpendicular to one another, or may represent different directions that are not perpendicular to one another. For the purposes of this disclosure, "at least one of X, Y, and Z" and "at least one selected from the group consisting of X, Y, and Z" may be construed as X only, Y only, Z only, or any combination of two or more of X, Y, and Z, such as, for instance, XYZ, XYY, YZ, and ZZ. As used herein, the term "and/or" includes any and all combinations of one or more of the associated listed items.

Although the terms "first," "second," and the like may be used herein to describe various types of elements, these elements should not be limited by these terms. These terms are used to distinguish one element from another element. Thus, a first element discussed below could be termed a second element without departing from the teachings of the disclosure.

Spatially relative terms, such as "beneath," "below," "under," "lower," "above," "upper," "over," "higher," "side" (for example, as in "sidewall"), and the like, may be used herein for descriptive purposes, and, thereby, to describe one element's relationship to other element(s) as illustrated in the drawings. Spatially relative terms are intended to encompass different orientations of an apparatus in use, operation, and/or manufacture in addition to the orientation depicted in the drawings. For example, if the apparatus in the drawings is turned over, elements described as "below" or "beneath" other elements or features would then be oriented "above" the other elements or features. Thus, the exemplary term "below" can encompass both an orientation of above and below. Furthermore, the apparatus may be otherwise oriented (for example, rotated 90 degrees or at other orientations), and, as such, the spatially relative descriptors used herein may likewise interpreted accordingly.

The terminology used herein is for the purpose of describing particular embodiments and is not intended to be limiting. As used herein, the singular forms, "a," "an," and "the" are intended to include the plural forms as well, unless the context clearly indicates otherwise. Moreover, the terms "comprises," "comprising," "includes," and/or "including," when used in this specification, specify the presence of stated features, integers, steps, operations, elements, components, and/or groups thereof, but do not preclude the presence or addition of one or more other features, integers, steps, operations, elements, components, and/or groups thereof. It is also noted that, as used herein, the terms "substantially," "about," and other similar terms, are used as terms of approximation and not as terms of degree, and, as such, are utilized to account for inherent deviations in measured, calculated, and/or provided values that would be recognized by one of ordinary skill in the art.

Various exemplary embodiments are described herein with reference to sectional and/or exploded illustrations that are schematic illustrations of idealized exemplary embodiments and/or intermediate structures. As such, variations from the shapes of the illustrations as a result, for example, of manufacturing techniques and/or tolerances, are to be expected. Thus, exemplary embodiments disclosed herein should not necessarily be construed as limited to the particular illustrated shapes of regions, but are to include deviations in shapes that result from, for instance, manufacturing. In this manner, regions illustrated in the drawings may be schematic in nature and the shapes of these regions may not reflect actual shapes of regions of a device and, as such, are not necessarily intended to be limiting.

As customary in the field, some exemplary embodiments are described and illustrated in the accompanying drawings in terms of functional blocks, units, and/or modules. Those skilled in the art will appreciate that these blocks, units, and/or modules are physically implemented by electronic (or optical) circuits, such as logic circuits, discrete components, microprocessors, hardwired circuits, memory elements, wiring connections, and the like, which may be formed using semiconductor based fabrication techniques or other manufacturing technologies. In the case of the blocks, units, and/or modules being implemented by microprocessors or other similar hardware, they may be programmed and controlled using software (for example, microcode) to perform various functions discussed herein and may optionally be driven by firmware and/or software. It is also contemplated that each block, unit, and/or module may be implemented by dedicated hardware, or as a combination of dedicated hardware to perform some functions and a processor (for example, one or more programmed microprocessors and associated circuitry) to perform other functions. Also, each block, unit, and/or module of some exemplary embodiments may be physically separated into two or more interacting and discrete blocks, units, and/or modules without departing from the scope of the inventive concepts. Further, the blocks, units, and/or modules of some exemplary embodiments may be physically combined into more complex blocks, units, and/or modules without departing from the scope of the inventive concepts.

Unless otherwise defined, all terms (including technical and scientific terms) used herein have the same meaning as commonly understood by one of ordinary skill in the art to which this disclosure pertains. Terms, such as those defined in commonly used dictionaries, should be interpreted as having a meaning that is consistent with their meaning in the context of the relevant art and should not be interpreted in an idealized or overly formal sense, unless expressly so defined herein.

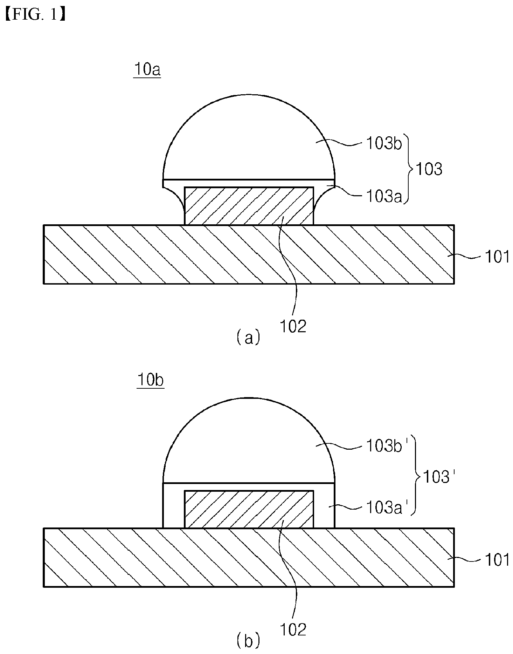

FIG. 1 is cross-sectional views of light emitting apparatuses 10a, 10b according to embodiments of the present disclosure. The light emitting apparatuses 10a, 10b according to the embodiments of the present disclosure may have multiple indices of refraction in at least a region of light emission regions.

Referring to FIG. 1, a light emitting apparatus may include a base substrate 101, a light emitting source 102, and a multi-refractive layer 103.

The base substrate 101 may include a mounting region in which one or more light emitting sources 102 may be mounted. The base substrate 101 serves to transmit electrical signals to the light emitting source 102 and may include wirings, pads, terminals, and the like for connection of a power source.

The base substrate 101 may be formed to have high thermal conductivity and high reflectivity (of a material having such properties) to increase luminous efficacy and reliability of the light emitting apparatus. For example, the base substrate 101 may be formed of a material, such as aluminum nitride (AlN) ceramics or Al₂O₃ ceramics, plastics including polymers and the like, acrylonitrile butadiene styrene (ABS), a liquid crystalline polymer (LCP), polyamide (PA), polyphenylene sulfide (IPS), or a thermoplastic elastomer (TPE), to have a structure including a pattern formed of a metallic material, such as Cu, W, Ag, Au and the like, for electrical conduction. The base substrate may also be a printed circuit board (PCB) using FR-4, FR-1 or FR-2 formed of glass fibers or a thermoplastic resin, or a metal, such as aluminum or Cu. By way of example, the base substrate 101 may have a thermal conductivity of about 170 W/mK. However, it should be understood that the material for the base substrate 101 is not limited thereto and may include various materials, such as GaAs, GaN, Si, Al, Cu, and/or sapphire. The light emitting source 102 may include at least a light emitting semiconductor device. The light emitting semiconductor device may generate and emit light through an active layer activated upon application of electric current. The light emitting semiconductor device may include a light emitting diode (LED) chip. The LED chip may include, for example, an LED chip that emits light having a wavelength in a particular wavelength band, such as ultraviolet light, blue light, green light, yellow light, red light, or infrared light. An upper portion of the active layer of the light emitting source 102 may have a certain index of refraction, for example, an index of refraction of 2.0 or more. The upper portion of a semiconductor layer of the light emitting source 102 may have a certain index of refraction, for example, an index of refraction of 1.5 or more.

The light emitting source 102 may further include a wavelength converter. The wavelength converter may be disposed in a light emission path of light emitted from the light emitting source. The wavelength converter may cover at least a region of the light emitting source 102. The wavelength converter may include at least a type of fine particles to convert wavelengths of light emitted from the light emitting source 102.

The fine particles may include phosphor particles, quantum dots, or organic dyes. For example, first type particles may include wavelength-conversion particles that emit light having a peak wavelength in the green or yellow wavelength band, and may include at least a of quantum dots, LuAG based particles, YAG based particles, beta-SiAlON based particles, nitride based particles, silicate based particles, halo-phosphide based particles, or oxynitride based particles, without being limited thereto. Second type particles may include red wavelength-conversion particles that emit light having a peak wavelength in the red wavelength band, and may include at least a of quantum dots, nitride based particles, such CASN, CASON, and SCASN, silicate based particles, sulfide based particles, or fluoride based particles, without being limited thereto.

The wavelength converter may be a film or sheet type wavelength converter, such as PIS (phosphor in silicon), PIG (phosphor in glass), and PIC (phosphor in ceramic). PIS may include silicone resins, such as methyl silicone or phenyl silicone, and may include an organic material, such as a fluoropolymer, an epoxy resin, polyphthalamide (PPA), polybutylene terephthalate (PBT), polycarbonate (PC), and the like, glass, such as borosilicate, aluminosilicate, soda-lime glass, and the like, and fused quartz.

The multi-refractive layer 103 may be disposed to cover at least a region of the light emitting source 102. Thus, the multi-refractive layer 103 may be disposed in an emission region of light generated from the light emitting source. The multi-refractive layer 103 may include regions having different indices of refraction with respect to light generated from the light emitting source 102. For example, the multi-refractive layer 103 may include regions with different indices of refraction with respect to light generated from the light emitting source in at least a region along an imaginary line horizontal to the light emitting source 102. Further, the multi-refractive layer 103 may include regions with different indices of refraction with respect to light generated from the light emitting source in at least a region along an imaginary line perpendicular to the light emitting source 102. In this embodiment, the multi-refractive layer 103 can increase the quantity of light through effective extraction of light emitted from the light emitting source 102 and can adjust the beam angle through reflection or refraction of light emitted from the light emitting source 102.

The multi-refractive layer 103 may be formed in a stable form using a solid material, for example, silicone resins, such as phenyl silicone, methyl silicone, and the like, sapphire, fused silica, borosilicate, soda-lime glass, aluminosilicate, Al₂O₃, ceramic, quartz, epoxy, fluoropolymer, polyphthalamide (PPA), polybutylene terephthalate (PBT), polycarbonate (PC), polyurethane, poly(methyl methacrylate) (PMMA), phenol resin, and the like. Furthermore, a portion of region of the multi-refractive layer 103 may include refractive regions formed of oxides, such as silicon oxide, zirconium oxide, titanium oxide, iron oxide, zinc oxide, and the like, or fluorides, such as magnesium fluoride, barium fluoride, calcium fluoride, aluminum fluoride, and the like. The effects of the multi-refractive layer 103 will be described below.

In addition, at least one layer of the multi-refractive layer 103 may include one or more types of fine particles in a region thereof. The fine particles may include a light diffusing material or a wavelength conversion material. When the multi-refractive layer 103 includes the light diffusing material, the light diffusing material may include PMMA beads, silica beads, hollow particles, silicone beads, MS beads, and the like. The light diffusing material added to the multi-refractive layer 103 can reflect or scatter light emitted from the light emitting source 102, thereby achieving uniform distribution of light over a large region while improving color uniformity. When the multi-refractive layer 103 includes the wavelength-conversion material, the wavelength-conversion material may include phosphor particles, quantum dots, or organic dyes. Specifically, the wavelength-conversion material includes wavelength-conversion particles emitting light having a peak wavelength in the green or yellow wavelength band and may include quantum dots, LuAG based particles, YAG based particles, beta-SiAlON based particles, nitride based particles, silicate based particles, halo-phosphide based particles, or oxynitride based particles. The wavelength-conversion material may include red wavelength-conversion particles that convert light having a peak wavelength in the red wavelength band, and may include one or more of quantum dots, nitride particles, such CASN, CASON, and SCASN, silicate particles, sulfide particles, or fluoride particles, without being limited thereto. The wavelength-conversion material added to the multi-refractive layer 103 may convert a fraction of light emitted from the light emitting source 102 to shift the color coordinates, thereby enabling expression of various colors.

The multi-refractive layer 103 may include a plurality of layers. The plurality of layers of the multi-refractive layer 103 may include materials having different indices of refraction in at least a region thereof. Each of the plurality of layers of the multi-refractive layer 103 may be formed of a material having a different refractive index.

In particular, FIG. 1 shows the light emitting apparatuses 10a, 10b according to the embodiments, in which each of the light emitting apparatuses 10a, 10b includes a substrate 101, a light emitting source 102, and a multi-refractive layer 103, 103'. In the light emitting apparatus 10, the multi-refractive layer 103 is disposed on the substrate 101 and includes a plurality of refractive layers. At least a refractive layer of the plurality of refractive layers of the multi-refractive layer 103 may at least partially cover the light emitting source 102. At least a refractive layer of the plurality of refractive layers of the multi-refractive layer 103 may include a curvature region.

Referring to FIG. 1, the multi-refractive layer 103, 103' may include a first refractive layer 103a, 103a' and a second refractive layer 103b, 103b'. The first refractive layer 103a, 103a' and the second refractive layer 103b, 103b' may include materials having different indices of refraction in at least regions thereof. In particular, assuming that the light emitting source 102 has an index of refraction RI₀, the first refractive layer 103a, 103a' has an index of refraction RI₁, the second refractive layer 103b, 103b' has an index of refraction RI₂, and an external air on the light emitting apparatus 10a, 10b has an index of refraction RIₐᵢᵣ, the index of refraction RI₀ of the light emitting source 102 is greater than the index of refraction RI₁ of the first refractive layer 103a, 103a', the index of refraction of the first refractive layer 103a, 103a' is less than the index of refraction RI₂ of the second refractive layer 103b, 103b', and the index of refraction RI₂ of the second refractive layer is greater than the refractive index RIₐᵢᵣ of the external air on the light emitting apparatus 10a, 10b.

Referring to FIG. 1(a), the multi-refractive layer 103 of the light emitting apparatus 10a may include a first refractive layer 103a and a second refractive layer 103b. The first refractive layer 103a and the second refractive layer 103b of light emitting apparatus 10a of FIG. 1(a) may have different shapes. The first refractive layer 103a may include a region adjoining the light emitting source 102 and a region adjoining the second refractive layer 103b. In the first refractive layer 103a, the region adjoining the light emitting source 102 and the region adjoining the second refractive layer 103b may overlap each other in at least a region thereof. The region of the first refractive layer adjoining the light emitting source 102 may have a larger area or a larger size than the region of the first refractive layer adjoining the second refractive layer to protect the light emitting source 102 from an external environment.

Further, the first refractive layer may include a region adjoining the substrate. Specifically, the first refractive layer may cover a side region of the light emitting source 102 while extending to a region of an upper region of the light emitting source 102. Here, the first refractive layer covering the side region of the light emitting source 102 may extend to the upper region of the substrate. Thus, the first refractive layer can improve extraction efficiency of light emitted from the side region of the light emitting source 102. Accordingly, the total quantity of light emitted from the light emitting apparatus 10a can be increased.

In addition, the first refractive layer 103a may include a curved region, which may have a smaller radius of curvature than a curved region of the second refractive layer 103b. Here, a fraction of light emitted from the side region can change a beam pattern of light by changing the light emission path through the curved region of the first refractive layer 103a. In addition, in such a structure, the multi-refractive layer 103 may surround the upper and side regions of the light emitting source 102 to obstruct penetration of corrosive gases or moisture, such as salt water and sulfur gas, thereby protecting the light emitting source 102 from corrosion.

Further, referring to FIG. 1(a), the second refractive layer 103b may be disposed above the light emitting source 102 to cover one region of the light emitting source 102. One region of the second refractive layer 103b may be disposed to cover one region of the first refractive layer 103a. A region of the second refractive layer 103b may adjoin one region of the first refractive layer 103a. At least a region of the first refractive layer 103a may be disposed between the light emitting source 102 and the second refractive layer 103b. The region of the first refractive layer 103a disposed between the light emitting source 102 and the first refractive layer 103a may include regions contacting the light emitting source 102 and the second refractive layer 103b, respectively. As such, the structure including the first refractive layer formed between the light emitting source 102 and the second refractive layer provides a longer moisture penetration path than a structure including a single refractive layer, thereby protecting the light emitting source 102 from corrosion by obstructing penetration of corrosive gas or moisture, such as salt water or sulfur gas.

Further, referring to FIG. 1(a), the first refractive layer 103a may have a curved region in at least a region thereof. In FIG. 1(a), the side region of the first refractive layer 103a may have a curvature such that an area of a horizontal cross-section of the first refractive layer 103a gradually increases with increasing vertical distance from an upper region of the substrate 100. The curvature of the first refractive layer 103a may be different from a curvature of the second refractive layer. With this structure, the first refractive layer 103a can change an emission path of light emitted from side regions of the light emitting device 102 through the curved region thereof and guide the light to pass through the second refractive layer 103b, thereby adjusting the beam pattern of light.

Referring to FIG. 1(b), at least a region of the first refractive layer 103a' may cover a side region of the light emitting source 102 and a region of the base substrate 101. The first refractive layer 103a' may have a constant area in a horizontal cross-section thereof. At least a region of the first refractive layer 103a' may have an angle perpendicular to the base substrate 101. In a region, cross-sectional areas of the first refractive layer 103a' and the second refractive layer 103b' may be the same. With such structure, the multi-refractive layer 103 can increase luminous efficacy through improvement in extraction of side emitting light and can protect the light emitting source 102 from corrosion by reducing a penetration path of corrosion gas or moisture, such as salt water or sulfur gas, which can penetrate along the base substrate.

Referring to FIG. 1(a) and FIG. 1(b), the second refractive layer 103b, 103b' may be formed in different shapes from the first refractive layer 103a, 103a'. When the first refractive layer 103a, 103a' has a quadrilateral shape, the second refractive layer 103b, 103b' may have a curved region in at least a region thereof. For example, the second refractive layer 103b, 103b' may have a hemispherical or dome shape. A height of the second refractive layer 103b, 103b' disposed on an upper region of the first refractive layer 103a, 103a' may be greater than or equal to a height of the first refractive layer or a chip. Here, the traveling path of light emitted from the light emitting source 102 reduces the beam angle of light emitted from the second refractive layer 103b, 103b', thereby realizing a narrow beam angle of light having passed through the multi-refractive layer while improving color purity through reduction in total reflection within the second refractive layer 103b, 103b'. In addition, the second refractive layer improves light extraction efficiency. Furthermore, the height of the second refractive layer 103b, 103b' disposed on the upper region of the first refractive layer 103a, 103a' may be less than or equal to the height of the first refractive layer or the chip. Here, as the curvature of the second refractive layer decrease, the beam angle of light emitted from the second refractive layer 103b, 103b' widens, thereby finally widening an irradiation area of light having passed through the multi-refractive layer while improving uniformity of light in the irradiation area. Referring to FIG. 1, the height from the upper region of the light emitting source 102 to the upper region of the first refractive layer 103a, 103a' disposed on of the light emitting source 102 is less than the height from the upper region of the substrate to the upper region of the light emitting source 102. Thus, reduction in height of the first refractive layer 103a, 103a' results in minimization of the traveling path of light emitted from the light emitting source 102 and passing through the first refractive layer 103a, 103a'. As a result, even if the first refractive layer 103a, 103a' is formed of materials, such as a urethane resin, an epoxy resin, or a phenyl silicone resin, whose internal bonds can be destroyed by light energy, it is possible to reduce damage, such as material discoloration or cracking, by light emitted from the light emitting source 102. In addition, it is possible to minimize light damage of the first refractive layer 103a, 103a' caused by light emitted from the light emitting source 102 providing high light energy, such as a short wavelength LED or a laser diode providing high light energy, thereby improving reliability. The first refractive layer 103a, 103a' may further include a light diffusive or light reflective material, such as carbon, TiO₂, silica, and the like, to change the emission path of light emitted from the light emitting source 102 and improve color uniformity. Further, when the light diffusive or light reflective material is further added to the first refractive layer 103a, 103a', transparency of the first refractive layer 103a, 103a' becomes lower than transparency of the second refractive layer 103b, 103b', thereby minimizing light loss while increasing the quantity of light emitted from the light emitting apparatus through minimization of a transmission path of light emitted from the light emitting source 102.

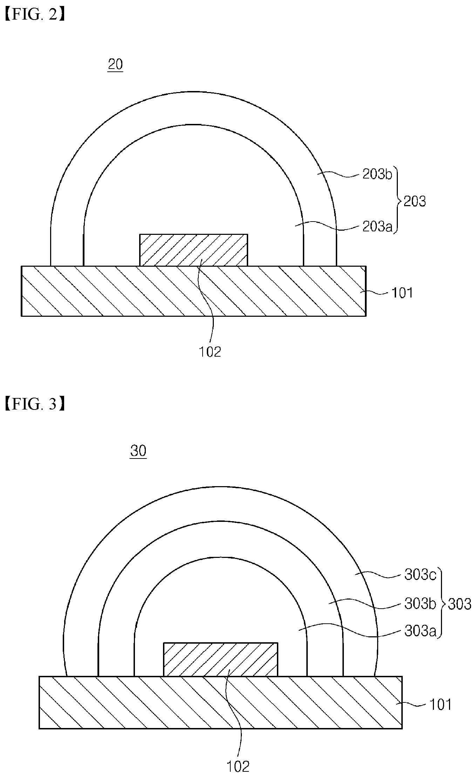

FIG. 2 is a cross-sectional view of a light emitting apparatus 20 according to an embodiment of the present disclosure.

Referring to FIG. 2, the light emitting apparatus 20 includes a base substrate 101, a light emitting source 102, and a multi-refractive layer 203. The base substrate 101 and the light emitting source 102 are the same as the base substrate 101 and the light emitting source 102 shown in FIG. 1 except for the multi-refractive layer 203, and thus detailed description thereof will be omitted.

The multi-refractive layer 203 may include a plurality of refractive layers. The plurality of refractive layers 203a, 203b of the multi-refractive layer 203 may have different indices of refraction with respect to light emitted from the light emitting source.

Referring to FIG. 2, the multi-refractive layer 203 may include a first refractive layer 203 a and a second refractive layer 203b. Each of the first refractive layer 203a and the second refractive layer 203b may include a curved region in a region thereof. The curved region of the first refractive layer 203a may have a different curvature from the curved region of the second refractive layer 203b. The second refractive layer 203b may be disposed on the base substrate 101 and may be separated from the light emitting source by the first refractive layer 203a while covering the upper and side regions of the light emitting source 102. The first refractive layer 203a may cover the upper and side regions of the light emitting source 102. A region of the first refractive layer 203a may be disposed between the base substrate 101 and the second refractive layer 203b and the other region of the first refractive layer 203a may be disposed between the light emitting source 102 and the second refractive layer 203b. A maximum width of the first refractive layer 203a may be less than a maximum width of the second refractive layer 203b.

Each of the first refractive layer 203a and the second refractive layer 203b may include an inner region and an outer region. The inner region of the first refractive layer 203a may be disposed to face the light emitting source 102 and the outer region of the first refractive layer 203a may be disposed to face the inner region of the second refractive layer 203b. The outer region of the second refractive layer 203b may be exposed to an external environment. The inner region of the first refractive layer 203a may include a region adjoining the light emitting source 102. Further, the inner region of the first refractive layer 203a may include a region adjoining the upper region of the substrate. The inner region of the second refractive layer 203b may be formed to adjoin the outer region of the first refractive layer 203a. Thus, the first refractive layer 203a may be disposed to cover the upper and side regions of the light emitting source 102 so as to cover a region thereof spaced apart from the base substrate 101 by a certain distance along a boundary between the light emitting source 102 and the upper region of the base substrate 101, thereby preventing external contaminants or moisture from entering the light emitting source. Further, the second refractive layer 203b is disposed on the first refractive layer 203a along the outer region of the first refractive layer 203a to cover a region thereof spaced apart from the base substrate 101 by an arbitrary distance along a boundary between the first refractive layer 203a and the upper region of the base substrate 101, thereby forming a double moisture-proof structure capable of preventing external contaminants or moisture from entering the light emitting source. Accordingly, the light emitting apparatus 20 can secure further improvement in reliability.

The first refractive layer 203a and the second refractive layer 203b may have different indices of refraction than adjacent layers. For example, assuming that the light emitting source 102 has an index of refraction RI₀, the first refractive layer 203a has an index of refraction RI₁, the second refractive layer 203b has an index of refraction RI₂, and an external air layer has an index of refraction RIₐᵢᵣ, the multi-refractive layer may satisfy relations of RI₀ > RI₁, RI₁ < RI₂, and RI₂ > RIₐᵢᵣ. In addition, when an n^{th} refractive layer has an index of refraction RIₙ, the multi-refractive layer may satisfy relations of RIₙ > RIₙ₋₁ and RIₙ > RIₙ₊₁. For example, the plurality of layers from an upper region of the active layer of the light emitting source to the external air layer may be disposed such that a pattern of indices of refraction is composed of alternate arrangement of high refractive index layers and low refractive index layers and the outermost refractive layer is a low refractive index layer. By alternately arranging the high refractive index layers and the low refractive index layers, light extraction efficiency of the light emitting apparatus 20 can be improved using a reflection effect caused by a difference in index of refraction between the plurality of layers and light emitted from the light emitting source can be refracted at a different angle in each layer to reduce loss of light due to trapping in a region.

FIG. 3 is a cross-sectional view of a light emitting apparatus 30 according to an embodiment of the present disclosure.

Referring to FIG. 3, the light emitting apparatus 30 includes a base substrate 101, a light emitting source 102, and a multi-refractive layer 303. The base substrate 101 and the light emitting source 102 according to this embodiment are the same as the base substrate 101 and the light emitting source 102 shown in FIG. 1 and FIG. 2 and detailed description thereof will be omitted.

Referring to FIG. 3, the multi-refractive layer 303 includes a first refractive layer 303a, a second refractive layer 303b, and a third refractive layer 303c for emission of light emitted from the light emitting source 102. The first refractive layer 303a, the second refractive layer 303b, and the third refractive layer 303c may have a curved region shape and may include regions stacked in the direction perpendicular to the base substrate 101. The vertically stacked regions of the first refractive layer 303a, the second refractive layer 303b, and the third refractive layer 303c may cover the upper region of the light emitting source 102. Further, the first refractive layer 303a, the second refractive layer 303b, and the third refractive layer 303c may include regions stacked in the direction horizontal to the base substrate 101. The horizontally stacked regions of the first refractive layer 303a, the second refractive layer 303b, and the third refractive layer 303c may cover at least a side region of a plurality of side regions of the light emitting source 102.

The plurality of refractive layers of the multi-refractive layer 303 may have different indices of refraction than adjacent layers. For example, assuming that the light emitting source has an index of refraction RI₀, the first refractive layer 303a has an index of refraction RI₁, the second refractive layer 303b has an index of refraction RI₂, the outermost refractive layer adjoining external air has an index of refraction RI_{fn}, and an external air layer has an index of refraction RIₐᵢᵣ, the multi-refractive layer may satisfy relations of RI₀ > RI₁ , RI₁ < RI₂, and RI_{fn} > RIₐᵢᵣ. In addition, when an n^{th} refractive layer has an index of refraction RIₙ, the multi-refractive layer may satisfy relations of RIₙ > RIₙ₋₁ and RIₙ > RIₙ₊₁ for at least one n. For example, the plurality of layers from the upper region of the active layer of the light emitting source to the external air layer may be disposed such that a pattern of indices of refraction is composed of alternate arrangement of high refractive index layers and low refractive index layers and the outermost refractive layer is a low refractive index layer. By alternately arranging the high refractive index layers and the low refractive index layers, light extraction efficiency of the light emitting apparatus 20 can be improved using the reflection effect caused by a difference in index of refraction between the plurality of layers and light emitted from the light emitting source can be refracted at a different angle in each layer to reduce loss of light due to trapping in a region.

Furthermore, when the multi-refractive layer 303 includes m layers (m being a natural number greater than or equal to 3), an n^{th} refractive layer corresponding to an n^{th} layer of the multi-refractive layer (n being greater than 1 and less than m) has an index of refraction RIₙ, an n-1^{th} refractive layer corresponding to an n-1^{th} layer of the multi-refractive layer has an index of refraction RIₙ₋₁, and an n+1^{th} refractive layer corresponding to an n+1^{th} layer of the multi-refractive layer has an index of refraction RIₙ₊₁, the index of refraction of the n^{th} refractive layer satisfies relations of RIₙ₋₁ < RIₙ and RIₙ₊₁ < RIₙ. In addition, when an external air environment has an atmospheric index of refraction RIₐᵢᵣ, the multi-refractive layer may satisfy RIₘ > RIₐᵢᵣ. Here, light extraction efficiency of the light emitting apparatus 20 can be improved using the reflection effect caused by a difference in index of refraction between the plurality of layers and light emitted from the light emitting source can be refracted at a different angle in each layer to reduce loss of light due to trapping in a region.

The second refractive layer 303b may be disposed between the first refractive layer 303a and the third refractive layer 303c. The first refractive layer 303a may be disposed between the base substrate 101 and the second refractive layer 303b. As such, instead of a refractive layer disposed at the outermost periphery of the light emitting apparatus 30, at least a refractive layer of the second refractive layer 303b or the first refractive layer 303a may include a region composed of fluid. Since the multi-refractive layer 303 according to this embodiment aims to improve luminous efficacy using a change in index of refraction along the light emission path, at least a refractive layer of the first refractive layer 303a or the second refractive layer 303b may include a gas or liquid layer or an air layer rather than a solid layer so long as the relations of the indices of refraction between the plurality of refractive layers are satisfied. Here, the air layer may include a low-activity gas, such as argon, helium, nitrogen, carbon dioxide, and the like, without being limited thereto.

When at least a refractive layer of the first refractive layer 303a or the second refractive layer 303b of the multi-refractive layer 303 includes a gas region, the gas region has an index of refraction close to 1, thereby enabling improvement in light extraction efficiency of the light emitting apparatus 30 through change in index of refraction based on the difference in index of refraction with a refractive layer adjacent thereto. Furthermore, corrosion of the device or other structure due to oxidation can be slowed down using a gas with low activity to improve reliability.

At least a refractive layer of the first refractive layer 303a or the second refractive layer 303b of the multi-refractive layer 303 may include a liquid region. The liquid layer may include silicone oil, Galden fluid, and the like, without being limited thereto. In this way, when at least a refractive layer of the first refractive layer 303a or the second refractive layer 303b of the multi-refractive layer 303 includes a liquid layer, it is possible to suppress degradation in light quantity of the light emitting apparatus 30 due to heat through reduction in temperature of the light emitting source 102 using not only a low index of refraction of the liquid layer, but also thermal conductivity of the liquid layer, thereby finally improving luminous efficacy and reliability of the light emitting apparatus 30.

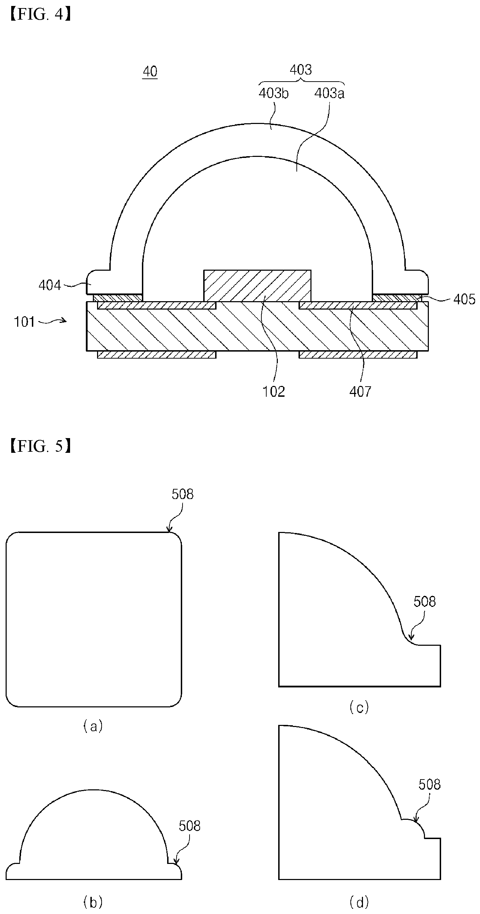

FIG. 4 is a cross-sectional view of a light emitting apparatus 40 according to an embodiment of the present disclosure.

Referring to FIG. 4, the light emitting apparatus 40 includes a base substrate 101, a light emitting source 102, and a multi-refractive layer 403. The base substrate 101 and the light emitting source 102 according to this embodiment are the same as the base substrate 101 and the light emitting source 102 shown in FIG. 1 or FIG. 3 and detailed description thereof will be omitted.

Referring to FIG. 4, the multi-refractive layer 403 includes a first refractive layer 403a and a second refractive layer 403b. The first refractive layer 403a is disposed between the base substrate 101 and the second refractive layer 403b, and the second refractive layer 403b is disposed on an outer region of the multi-refractive layer 403. The basic configuration and features of the first refractive layer 403a and the second refractive layer 403b may include the same configuration as the multi-refractive layer of FIG. 1 or FIG. 2.

In addition, the second refractive layer 403b of the multi-refractive layer 403 shown in FIG. 4 may include a spacer 404. The second refractive layer 403b and the spacer 404 of the multi-refractive layer 403 may be formed of the same material according to embodiments. The spacer 404 of the second refractive layer 403b may extend from a distal end of the second refractive layer 403b, specifically in a direction away from the light emitting source. Thus, the spacer 404 may include a region parallel to the base substrate 101 in at least a region thereof. Additionally, the spacer 404 may include a flat region. Furthermore, the flat region of the spacer 404 may be parallel to at least a region of the base substrate 101. The region of the spacer 404 parallel to the base substrate 101 can increase a bonding area upon bonding of the second refractive layer 403b to the base substrate 101 to improve bonding strength between the multi-refractive layer 403 and the substrate, thereby improving structural stability of the light emitting apparatus 40.

The light emitting apparatus 40 may further include a stereobate 405 between the multi-refractive layer 403 and the base substrate 101. The stereobate 405 may be provided to the base sub strate 101 or a lower region of the multi-refractive layer 403. Referring to FIG. 4, the stereobate 405 is disposed to adjoin a region of the multi-refractive layer 403. The stereobate 405 can improve the quality of light emitted from the light emitting apparatus 40 by absorbing light emitted from the light emitting source 102 and directed towards the base substrate 101 or by reflecting the light towards the multi-refractive layer 403 or the spacer 404. In addition, the stereobate 405 can improve the quantity of light emitted from the light emitting apparatus 40 by reflecting light directed towards a lower side of the multi-refractive layer 403 and can improve the quality of light emitted from the light emitting apparatus 40 by absorbing side emitting light having a lower color temperature than the center of the light emitting source 102 to reduce chromatic aberration.

Furthermore, the stereobate 405 may be disposed between the multi-refractive layer 403 and the base substrate 101 to improve bonding strength between the multi-refractive layer 403 and the base substrate 101. Here, the stereobate 405 can relieve a difference in coefficient of thermal expansion between the multi-refractive layer 403 and the base substrate 101. Thus, the stereobate 405 may include a material having an intermediate value between the coefficients of thermal expansion of the multi-refractive layer 403 and the base substrate 101. Accordingly, the stereobate 405 can address reliability issues, such as mechanical defects or micro-cracking of the light emitting apparatus 40.

In another embodiment, the stereobate 405 may further include an adhesive layer including metallic materials or fine particles capable of improving light absorption or light reflectivity. The adhesive layer of the stereobate 405 may be formed of a thermosetting resin, such as a silicone resin, an epoxy resin, or a polyurethane resin, or a UV-curable adhesive, and may further include fine particles to improve light reflectivity or light absorption, such as titanium oxide, magnesium oxide, zinc oxide, magnesium carbonate, magnesium hydroxide, calcium carbonate, calcium hydroxide, silicon oxide, calcium silicate, magnesium silicate, barium titanate, barium sulfate, aluminum hydroxide, aluminum oxide, zirconium oxide, carbon, and the like.

The stereobate 405 may also be formed of a metal, such as gold (Au), silver (Ag), copper (Cu), aluminum (Al), and the like, or alloys thereof. In particular, a hermetic seal may be used upon metal joining using alloys, such as Kovar, Invar and cobalt chrome, tungsten, molybdenum, titanium, solders, and the like. The hermetic seal can protect the light emitting source 102 from an external environment with high temperature, high humidity, or salt water, thereby improving reliability of the light emitting apparatus.

Referring to FIG. 4, the light emitting apparatus may further include a patterned layer 407 to improve adhesion between the multi-refractive layer 403 and the base substrate 101. The patterned layer 407 is disposed between the multi-refractive layer 403 and the base substrate 101 and may be disposed so as to overlap the stereobate in a region thereof. In addition, the patterned layer 407 may partially adjoin the multi-refractive layer 403 or the stereobate 405 to increase bonding strength between the multi-refractive layer 403 and the base substrate 101. The patterned layer 407 may be formed of a metal, such as Cu, Au, Ag, Fe, Al, Ni, Sn, and the like, or alloys thereof, or may be formed of a non-metallic material, such as ceramic, silicone, epoxy, and the like, or the same material as the base substrate 101, without being limited thereto. The patterned layer 407 serves to improve not only structural bonding strength of the light emitting apparatus 40, but also light extraction efficiency by reflecting light emitted from the light emitting source 102 and directed to the base substrate 101 so as to travel towards the multi-refractive layer 403.

FIG. 5 is views of a stress reduction region 508 of a light emitting apparatus 50 according to an embodiment of the present disclosure.

In particular, the light emitting apparatus shown in FIG. 5 has the same configuration as the light emitting apparatuses shown in FIG. 1 or FIG. 4 except for the stress reduction region 508, and for convenience of description, it is assumed that the stress reduction region 508 is disposed in an outer peripheral region of the second refractive layer 403b shown in FIG. 4.

Referring to FIG. 5, the light emitting apparatus may include the stress reduction region 508. The stress reduction region 508 may be disposed in an outer peripheral region of the refractive layer.

The stress reduction region 508 may extend from a distal end of the outer peripheral region of the second refractive layer 403b to form a curved region having a certain curvature, as shown in (a) and (b) of FIG. 5.

Further, the curved region of the stress reduction region 508 may include a concave region that is concave towards the light emitting source 102, as shown in FIG. 5(c). The stress reduction region 508 may include a region having a cross-sectional area gradually increasing with decreasing distance to the light emitting source 102, and a slope gradually decreasing with decreasing distance to the light emitting source 102. Alternatively, the curved region of the stress reduction region 508 may include a convex region that is convex outwards with respect to the upper region of the substrate 101, as shown in (d) of FIG. 5. The stress reduction region 508 may include a region having a cross-sectional area gradually increasing with decreasing distance to the light emitting source 102, and a slope gradually increasing with decreasing distance to the light emitting source 102.

As such, the stress reduction region 508 may be disposed in an outer peripheral region of the second refractive layer 403b disposed at an outer periphery of the multi-refractive layer 403 to relieve stress concentrated on a corner region of the multi-refractive layer 403. With this structure, the stress reduction region 508 can reduce a possibility of breakage of the multi-refractive layer 403 due to stress.

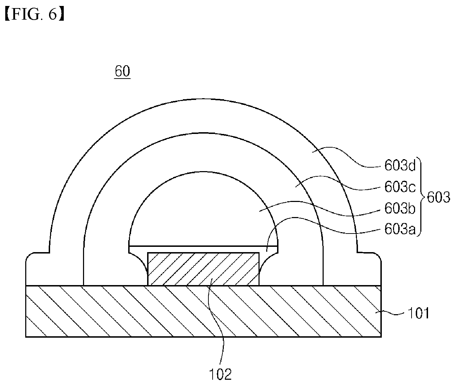

FIG. 6 is a cross-sectional view of a light emitting apparatus 60 according to an embodiment of the present disclosure.

Referring to FIG. 6, the light emitting apparatus 60 may include the same configuration as the light emitting apparatuses of FIG. 1 to FIG. 5 excluding a multi-refractive layer 603.

Referring to FIG. 6, the multi-refractive layer 603 includes a first refractive layer 603a, a second refractive layer 603b, a third refractive layer 603c, and a fourth refractive layer 603d. The first refractive layer 603a, the second refractive layer 603b, the third refractive layer 603c, and the fourth refractive layer 603d may have different indices of refraction from adjacent layers. For example, assuming that the light emitting source 102 has an index of refraction RI₀, the first refractive layer 603a has an index of refraction RI₁, the second refractive layer 603b has an index of refraction RI₂, the third refractive layer 603c has an index of refraction RI₃, the fourth refractive layer 603d has an index of refraction RI₄, and external air has an index of refraction RIₐᵢᵣ.

The multi-refractive layer 603 shown in FIG. 6 may satisfy conditions that the index of refraction RI₀ of the light emitting source 102 may be greater than the index of refraction RI₁ of the first refractive layer 603a, the index of refraction RI₁ of the first refractive layer 603a is lower than the index of refraction RI₂ of the second refractive layer 603b, the index of refraction RI₂ of the second refractive layer 603b is greater than the index of refraction RI₃ of the third refractive layer 603c, the index of refraction RI₃ of the third refractive layer 603c is lower than the index of refraction RI₄ of the fourth refractive layer 603d, and the index of refraction RI₄ of the fourth refractive layer 603d is greater than the index of refraction RIₐᵢᵣ of the external air outside the light emitting device 60. That is, assuming that an external air layer has an index of refraction RIₐᵢᵣ, the multi-refractive layer 603 may satisfy relations: RI₀ > RI₁, RI₁ < RI₂ , RI₂ > RI₃, RI₃ < RI₄, and RI₄ > RIₐᵢᵣ. In addition, when the n^{th} refractive layer has an index of refraction RIₙ, the multi-refractive layer 603 may satisfy relations: RIₙ > RIₙ₋₁ and RIₙ > RIₙ₊₁ for at least one n.

The first refractive layer 603a of the multi-refractive layer 603 may be disposed to cover the upper region of the light emitting source 102 and at least a region of a side region of the light emitting source 102. The first refractive layer 603a may be formed such that a distance from the upper region of the light emitting source 102 to an upper region of the first refractive layer 603 a is less than a distance from the upper region of the substrate 101 to the upper region of the light emitting source 102. The first refractive layer 603a may have a larger area than one region of the light emitting source 120. The second refractive layer 603b may be disposed to cover one region of the light emitting source 102 and to have one region overlapping the upper region of the first refractive layer 603a. The second refractive layer 603b may have a larger area than the first refractive layer 603a. The second refractive layer 603b may have a greater radius of curvature than the first refractive layer 603a.

The third refractive layer 603c may be disposed between the base substrate 101 and the fourth refractive layer 603d to cover the first refractive layer 603a and the second refractive layer 603b. The third refractive layer 603c may have a larger area than the first refractive layer 603a and the second refractive layer 603b. The third refractive layer 603c may have a greater radius of curvature than the first refractive layer 603a and the second refractive layer 603b. The third refractive layer 603c may have a smaller curvature than the first refractive layer 603a and the second refractive layer 603b. The third refractive layer 603c may have a narrower cross-sectional area than the fourth refractive layer 603d. The third refractive layer 603c may have a greater curvature than the fourth refractive layer 603d. The third refractive layer 603c may have a smaller radius of curvature than the fourth refractive layer 603d. The fourth refractive layer 603d may be disposed at an outer periphery of the multi-refractive layer 603 to cover the first refractive layer 603a, the second refractive layer 603b, and the third refractive layer 603c. The fourth refractive layer 603d may have a greater radius of curvature than the first refractive layer 603a, the second refractive layer 603b, and the third refractive layer 603c disposed inside the fourth refractive layer 603d. The fourth refractive layer 603d may have a smaller curvature than the first refractive layer 603a, the second refractive layer 603b, and the third refractive layer 603c disposed inside the fourth refractive layer 603d. The multi-refractive layer 603 may have the curvatures sequentially decreasing outwards from the light emitting source 601 to improve light extraction efficiency. The fourth refractive layer 603d may have higher hardness than at least a refractive layer of the first refractive layer 603a, the second refractive layer 603b, or the third refractive layer 603c disposed inside the fourth refractive layer 603d. With this structure, the fourth refractive layer 603d can protect the light emitting source 102 from external pressure or impact.

The multi-refractive layer 603 may include a region in which the first refractive layer 603a, the second refractive layer 603b, the third refractive layer 603c, and the fourth refractive layer 603d are stacked or overlap each other in the direction perpendicular to the base substrate 101. The stacked region of the first to fourth refractive layers 603a, 603b, 603c, 603d overlapping each other in the direction perpendicular to the base substrate 101 may include a region overlapping the upper region of the light emitting source 102. Thus, a refractive layer disposed in a region away from the base substrate 101 in the direction perpendicular to the base substrate 101 may have a smaller curvature than a refractive layer close to the base substrate 101. The multi-refractive layer 603 may include a region in which at least three refractive layers of the first refractive layer 603a, the second refractive layer 603b, the third refractive layer 603c, or the fourth refractive layer 603d overlapping each other in the direction horizontal to the base substrate 101. In the region of the multi-refractive layer 603 including the refractive layers overlapping each other in the direction horizontal to the base substrate 101, the type of refractive layers overlapping each other may vary based on a certain height from the upper region of the light emitting source 102. The height from the upper region of the light emitting source 102 may be substantially the same as the distance from the upper region of the light emitting source 102 to the upper region of the first refractive layer 603a. In a region of the multi-refractive layer 603 under the height from the upper region of the light emitting source 102, the first refractive layer 603a, the third refractive layer 603c, and the fourth refractive layer 603d may be stacked next to each other in the direction horizontal to the base substrate 101. In a region of the multi-refractive layer 603 over the height from the upper region of the light emitting source 102, the second refractive layer 603b, the third refractive layer 603c, and the fourth refractive layer 603d may be stacked next to each other in the direction horizontal to the base substrate 101, thereby increasing the beam angle in the horizontal direction through adjustment of a light emission direction.

As such, with different configurations of the plurality of refractive layers depending on the region of the multi-refractive layer 603, the multi-refractive layer 603 can change the beam pattern of light emitted from the light emitting source 102 into various shapes rather than a simple radial shape. For example, the light path may be changed to allow a greater quantity of light to be emitted in a region of 30 degrees or more relative to the center of the light emitting source 102 than at the center of the light emitting source. Alternatively, the light path may be designed to allow light at a viewing angle of 40 degrees or more relative to the center of the light emitting source 102 to have an illuminance that is 50% or less of illuminance at the center of the light emitting source 102.

At least a refractive layer of the first refractive layer 603a, the second refractive layer 603b, or the third refractive layer 603c other than the fourth refractive layer 603d disposed at the outer periphery of the multi-refractive layer 603 may include a gas or liquid region as in the multi-refractive layer 303 of FIG. 3 and effects thereof may be substantially the same as those of the multi-refractive layer of FIG. 3.

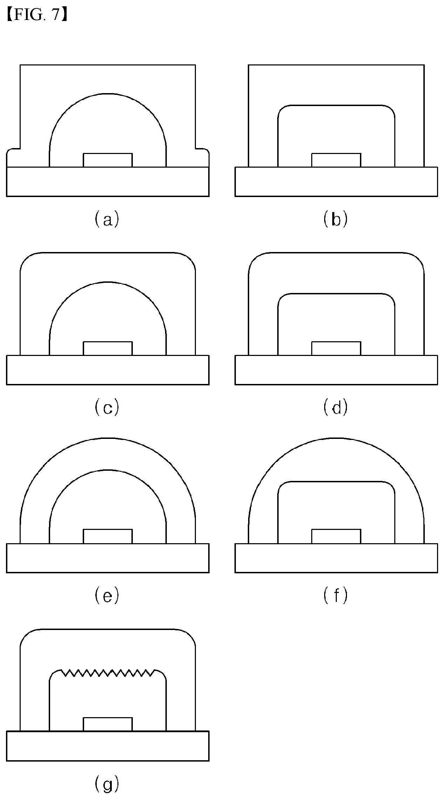

FIG. 7 is exemplary views of various shapes of a multi-refractive layer according to embodiments of the present disclosure. Although it is assumed that the multi-refractive layer includes the first refractive layer and the second refractive layer in the drawings, it should be understood that the multi-refractive layer may further include additional layers without limitation.

FIG. 7(a) shows an embodiment in which the first refractive layer includes a curvature region and the second refractive layer includes an inner curvature region and an outer straight region. The curvature region of the first refractive layer can improve light extraction efficiency by changing the light emission path. The inner curvature region of the second refractive layer can improve light extraction efficiency by widening the path of light reflected towards the first refractive layer over a critical angle to reflect the light towards the outside of the second refractive layer. In addition, the outer straight region of the second refractive layer can widen the light emission path by refracting the light.

Referring to FIG. 7(b), the first refractive layer may include at least a straight region and at least a curvature region. In addition, the second refractive layer may include a straight region and a curvature region. Further, the second refractive layer includes an outer straight region. The outer curvature region of the first refractive layer may have the same curvature as the inner curvature region of the second refractive layer. The straight region of the first refractive layer can narrow a light emission angle at an interface thereof. The inner straight region of the second refractive layer can widen the beam angle of the light emitting apparatus by reflecting light directed towards the first refractive layer to a side region thereof. The outer straight region of the second refractive layer can widen the light emission path by refracting light.

FIG. 7(c) shows an embodiment in which the first refractive layer includes an outer curvature region and the second refractive layer includes an outer curvature region. The second refractive layer may further include an inner curvature region. In addition, the second refractive layer may include at least an outer straight region. The outer curvature region of the first refractive layer may have a smaller curvature than the outer region of the second refractive layer. The second refractive layer may include a smaller radius of curvature than the first refractive layer in a region. The curvature region of the first refractive layer can improve light extraction efficiency by changing the light emission path. The inner curvature region of the second refractive layer can improve light extraction efficiency by widening the path of light reflected towards the first refractive layer over a critical angle to reflect the light towards the outside of the second refractive layer. The outer straight region of the second refractive layer can widen the light emission path by refracting light. The outer curvature region of the second refractive layer can increase the quantity of light directed to the outside of the light emitting apparatus through reduction in total reflection of light incident thereon.

FIG. 7(d) shows an embodiment in which the first refractive layer and the second refractive layer may each include at least a straight region and at least an outer curvature region. Additionally, the first refractive layer and the second refractive layer may each include at least an inner curvature region. Here, the first refractive layer may include an outer curvature region, in which the outer curvature of the first refractive layer may be equal to an inner curvature of the second refractive layer. And the first refractive layer may include an outer curvature region, in which the outer curvature of the first refractive layer may be larger than or equal to an outer curvature of second refractive layer. Further, the second refractive layer may include at least an inner straight region and the first refractive layer may include an outer straight region. An inner straight region of the first refractive layer may have a narrower area than the inner straight region of the second refractive layer. The outer straight region of the first refractive layer may have an equal area to the inner straight region of the second refractive layer. And the outer straight region of the first refractive layer may have a narrower area than the outer straight region of the second refractive layer. Here, the outer straight region of the first refractive layer can narrow a light emission angle at an interface thereof. Further, the inner straight region of the second refractive layer can widen the beam angle of the light emitting apparatus by reflecting a fraction of light directed towards the first refractive layer to a side region thereof. The outer straight region of the second refractive layer can widen the light emission path by refracting light. Here, the outer curvature region of the second refractive layer can increase the quantity of light directed to the outside of the light emitting apparatus through reduction in total reflection of light incident thereon.

FIG. 7(e) shows an embodiment in which the first refractive layer has a curvature on an outer region thereof and the second refractive layer has curvatures on inner and outer regions thereof. The curvature of the inner region of the second refractive layer may be equal to the curvature of the outer region of the first refractive layer. The curvature of the outer region of the second refractive layer may be smaller than the curvature of the outer region of the first refractive layer. The curvature region of the outer region of the second refractive layer may have a greater radius of curvature than the curvature region of the outer region of the first refractive layer. Here, the curvatures of the refractive layers may be decreased sequentially and the radii of curvature can be sequentially varied at an interface thereof to improve light extraction efficiency. The curvature region of the first refractive layer can improve light extraction efficiency by changing the light emission path. The inner curvature region of the second refractive layer can improve light extraction efficiency by widening the path of light reflected towards the first refractive layer part over a critical angle to reflect the light towards the outside of the second refractive layer. The outer curvature region of the second refractive layer can improve light extraction efficiency by making the path of light emitted to the outside of the second refractive layer less than the critical angle.

FIG. 7(f) shows an embodiment in which the first refractive layer includes an outer straight region and an outer curvature region, and the second refractive layer includes an inner straight region, inner curvature region and an outer curvature region. The outer curvature region of the first refractive layer may have a greater curvature than the outer curvature region of the second refractive layer. In addition, the outer curvature region of the first refractive layer may have a smaller radius of curvature than the outer curvature region of the second refractive layer. Light emitted to the straight region of the first refractive layer can narrow the light emission path at an interface thereof. In addition, the inner straight region of the second refractive layer can widen the beam angle of the light emitting apparatus by reflecting a fraction of light directed towards the first refractive layer to a side region thereof. The outer curvature region of the second refractive layer can improve light extraction efficiency by making the path of light emitted to the outside of the second refractive layer less than a critical angle.

FIG. 7(g) shows an embodiment in which the multi-refractive layer includes a roughness region. In this embodiment, the multi-refractive layer may have a shape in which roughness is added to the shapes of (a) to (f) of FIG. 7. Although the roughness region is shown as being formed between the first refractive layer and the second refractive layer for convenience in FIG. 7(g), without being limited thereto, the roughness may be formed in any region of the refractive layer. The roughness region may be disposed at a boundary of each refractive layer of the multi-refractive layer to change the path of incident or exit light in multiple directions, thereby improving light extraction efficiency through reduction in quantity of light reflected along the same path to be trapped therein.

At least a refractive layer of the multi-refractive layers of (a) to (g) of FIG. 7 may include spacers. The spacer can increase bonding strength by increasing the bonding area with the refractive layer. In addition, the spacer can improve fracture strength of the multi-refractive layer to reduce failure due to detachment of the multi-refractive layer.

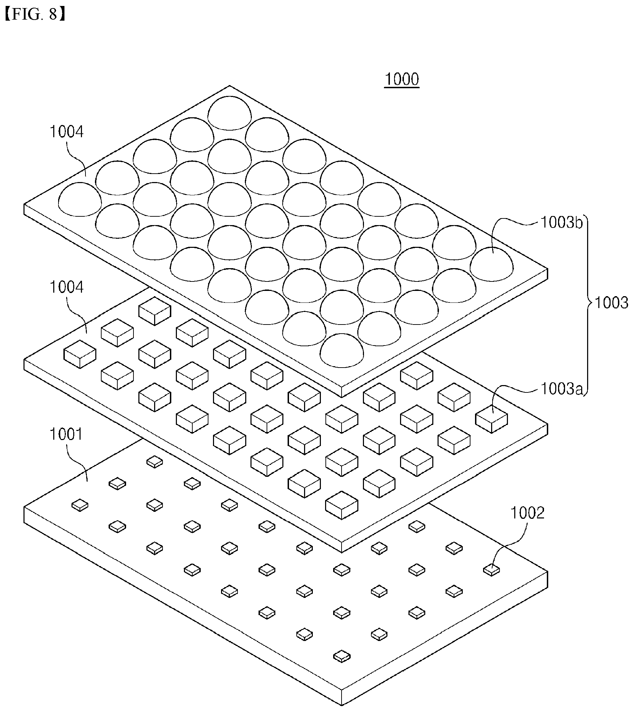

FIG. 8 illustrates a light emitting module 1000 including a light emitting apparatus according to an embodiment of the present disclosure. In particular, the light emitting module 1000 shown in FIG. 8 may include the light emitting apparatus realized as described in FIG. 1 to FIG. 7.

Referring to FIG. 8, the light emitting module 1000 includes a module substrate 1001 and a plurality of light emitting apparatuses. The plurality of light emitting apparatus includes pluralities of light emitting sources 1002 and multi-refractive layers 1003 for emitting light emitted from the plurality of light emitting sources 1002. The module substrate 1001 serves to have the plurality of light emitting sources 1002 mounted thereon to deliver electricity or signals thereto and may include a circuit board including interconnections to apply power. Here, the base substrate of the light emitting apparatus may be omitted.

The plurality of light emitting sources 1002 may be arranged in one or more rows and columns on the module substrate 1001. For example, the light emitting sources may be arranged at regular intervals. Alternatively, the light emitting sources 1002 may be arranged such that distances between at least three light emitting sources 1002 are equal to each other. However, it should be understood that the light emitting sources are not limited to this arrangement and may be arranged in a circular, spiral, radial, hexagonal, or other arrangement, without being limited thereto. The plurality of light emitting sources 1002 may output text, images, or the like through such arrangement.

In addition, at least two of the light emitting sources 1002 may have different color coordinates. Through adjustment of electric current of the at least two light emitting sources having different color coordinates, the light emitting module can realize colors between the different color coordinates, thereby enabling expression of various colors.

The multi-refractive layers 1003 can externally extract light from the plurality of light emitting sources 1002 to improve light extraction efficiency and can adjust a light emission angle to allow expression of various colors by mixing or separating light emitted from the plurality of light emitting sources 1002. In addition, the multi-refractive layers 1003 can have the same effects as the multi-refractive layers 1003 of the aforementioned embodiments, without being limited thereto.

The multi-refractive layers 1003 may be independently disposed corresponding to each of the light emitting sources. The multi-refractive layers 1003 may be arranged in an array corresponding to each of the light emitting sources. When the multi-refractive layer 1003 is composed of a plurality of layers, the layers of the multi-refractive layer may be disposed corresponding to the light emitting sources, respectively. Further, each layer of the multi-refractive layer may include a region overlapping the light emitting source when arranged corresponding to each light emitting source.

In addition, at least a refractive layer of the multi-refractive layers 1003 may be spaced apart from each other so as to correspond to the light emitting sources 1002, respectively. The refractive layers spaced apart from each other can provide narrow light emission paths such that light emitted from one light emitting source 1002 does not mix with light emitted from another light emitting source.

Further, at least a region of the multi-refractive layer 1003 may have a rough region, i.e., roughness shape. The roughness shape on one region of the multi-refractive layer can increase light extraction efficiency by reducing total reflection and trapping of light inside the refractive layer through diversification of an angle of reflected light at an interface of the refractive layers.

In addition, at least a refractive layer of the multi-refractive layer 1003 may be attached to at least a region of the light emitting source 1002. With this structure, the multi-refractive layer 1003 can adjust the beam angle of light emitted from the light emitting sources 1002 to facilitate design of light emitting apparatuses while improving quality thereof.

By way of example, when the multi-refractive layers 1003 are partially bonded to the upper regions of the light emitting sources 1002, the multi-refractive layers 1003 can provide narrow beam angles through refraction of light emitted from the upper regions thereof. With design of providing narrow beam angles, the multi-refractive layers 1003 can improve color purity and contrast while reducing blooming by minimizing light interference through improvement in straightness of light emitted from the light emitting sources 1002, thereby improving the quality of an apparatus, such as a display or a signage (e.g. Digital information Display).

On the other hand, when at least a refractive layer of the multi-refractive layers 1003 adjoin the side regions of the light emitting sources 1002, the multi-refractive layers 1003 can increase the quantity of light through extraction of side emitting light of the light emitting sources 1002 and provide a typical wide beam angle. The wide beam angle can widen illuminance while reducing chromatic aberration of sheet light sources, thereby facilitating fabrication of the sheet light sources, such as backlight units (BLUs) or sheet lighting.

Furthermore, a refractive region of the multi-refractive layer 1003 may be composed of a gas. Since the multi-refractive layers according to the embodiments are designed to improve optical efficiency through variation of the index of refraction along the light emission path, a gas, liquid, or air layer rather than a solid layer may be used as the refractive layer so long as the relations between the indices of refraction is satisfied. The effects of the gaseous region may be similar to those described in FIG. 7.

at least a refractive layer of each of the multi-refractive layers 1003 may include a spacer 1004. The spacer 1004 can increase a bonding area with the base substrate 1001, the light emitting source 1002, or other components of the multi-refractive layer to increase adhesion therebetween, thereby improving physical reliability. The spacers may also serve to maintain arrangement of the multi-refractive layers 1003.

The spacer 1004 may include a stress reduction region. The stress reduction region may include a curvature region to reduce stress and physical damage caused thereby and to improve light extraction efficiency by providing an angle of incidence of laterally incident light less than a critical angle.

A stereobate may be added to the lower region of each of the multi-refractive layers 1003 or to the upper region of the base substrate 1001. The stereobate can increase luminous efficacy and/or color uniformity through reflection or absorption of light incident on the lower region of the refractive layer.

The detailed description of preferred embodiments of the present disclosure disclosed above has been provided to allow those skilled in the art to implement and practice the present disclosure. Although some embodiments have been described herein, it should be understood by those skilled in the art that various modifications, variations and alterations may be made without departing from the scope of the disclosure. For example, those skilled in the art may utilize each of the configurations described in the above embodiments in combination with each other.

Therefore, it should be understood that the present disclosure is not intended to be limited to the embodiments herein, but rather to provide the broadest scope consistent with principles and novel features disclosed herein.

Further exemplary embodiments are described in the following paragraphs.

Example 1: A light emitting apparatus comprising:
a base substrate;
a light emitting source disposed on the base substrate; and
a multi-refractive layer including a plurality of refractive layers disposed on the light emitting source, the multi-refractive layer comprising:
   m layers (m being a natural number greater than or equal to 3),
   an n^{th} refractive layer corresponding to an n^{th} layer of the multi-refractive layer (n being greater than 1 and less than m) and having an index of refraction RIₙ;
   an n-1^{th} refractive layer corresponding to an n-1^{th} layer of the multi-refractive layer and having an index of refraction RIₙ₋₁; and
   an n+1^{th} refractive layer corresponding to an n+1^{th} layer of the multi-refractive layer and having an index of refraction RIₙ₊₁,
   wherein, for at least one n, the index of refraction RIₙ is greater than the index of refraction RIₙ₋₁ and is greater than the index of refraction RIₙ₊₁.

Example 2: The light emitting apparatus according to Example 1, wherein the last refractive layer of the multi-refractive layer has an index of refraction RI_{fn}, the index of refraction RI_{fn} being greater than an index of refraction of external air.

Example 3: The light emitting apparatus according to Example 1 or 2, wherein a first refractive layer of the multi-refractive layer adjacent to the light emitting source has a lower refractive index than the light emitting source.

Example 4: A light emitting module comprising:
a module substrate;
a light emitting source disposed on the module substrate; and
a multi-refractive layer disposed on the light emitting source,
wherein the multi-refractive layer includes a first refractive layer and a second refrac tive layer disposed outside the first refractive layer, the first refractive layer having a lower index of refraction than the second refractive layer.

Example 5: The light emitting module according to Example 4, wherein at least one of to layers of the multi-refractive layer comprises a spacer including a flat regi on being parallel to at least a region of the module substrate and having a predeter mined thickness.

Example 6: The light emitting module according to Example 4 or 5, wherein the module substrate and the multi-refractive layer is provided with a stereobate on at le ast a region of the module substrate or the multi-refractive layer.

Example 7: The light emitting module according to any one of Examples 4 to 6, wherein at least a refractive layer of the first refractive layer or the second refractiv e layer includes a roughness region.

Example 8: The light emitting module according to any one of Examples 4 to 7, wherein the first refractive layer has a lower index of refraction than the at least a l ight emitting source.

Example 9: The light emitting module according to any one of Examples 4 to 8, wherein a region of the first refractive layer adjoins a region of the light emitting s ource.

Example 10: The light emitting module according to any one of Examples 4 to 9, wherein at least a layer of the multi-refractive layer is composed of a gas.

Example 11: A display comprising the light emitting module according to any one of Examples 4 to 10.

### [List of Reference Numerals]

10, 20, 30, 40, 60: Light emitting apparatus
1000: Light emitting module
101: Base substrate
1001: Module substrate
102, 1002: Light emitting source
103, 203, 303, 403, 603, 1003: Multi-refractive layer
103a, 203a, 303a, 403a, 503a, 603a, 1003a: First refractive layer
103b, 203b, 303b, 403b, 503b, 603b, 1003b: Second refractive layer
303c, 603c: Third refractive layer
603d: Fourth refractive layer
404, 1004: Spacer
405: Stereobate
407: Pattern
508: Stress reduction region

## Claims

1. A light emitting apparatus comprising:
a base substrate;
a light emitting source disposed on the base substrate; and
a multi-refractive layer disposed on the light emitting source,
wherein the multi-refractive layer comprises a first refractive layer and a second refractive layer disposed outside the first refractive layer, the first refractive layer having a lower index of refraction than the second refractive layer.

2. The light emitting apparatus according to claim 1, wherein the first refractive layer or the second refractive layer includes a curvature region.

3. The light emitting apparatus according to claim 1 or 2, wherein the first refractive layer or the second refractive layer includes a flat region.

4. The light emitting apparatus according to any one of claims 1 to 3, wherein at least one layer of the multi-refractive layer comprises a gas or a liquid.

5. The light emitting apparatus according to any one of claims 1 to 4, further comprising a spacer including a region parallel to at least a region of the base substrate and having a predetermined thickness, the spacer comprising a stress reduction region having a curved region.

6. The light emitting apparatus according to any one of claims 5,
wherein, an outermost refractive layer of the multi-refractive layer covers an upper region of the light emitting source.

7. The light emitting apparatus according to any one of claims 1 to 6, wherein the base substrate and the multi-refractive layer comprise a stereobate formed on at least a region of the base substrate or the multi-refractive layer.

8. The light emitting apparatus according to any one of claims 1 to 7, wherein at least a region of multi-refractive layer includes a roughness shape.

9. The light emitting apparatus according to any one of claims 1 to 8, wherein the light emitting source has a refractive index, and the first refractive layer has a lower index of refraction than the light emitting source.

10. The light emitting apparatus according to any on of claims 1 to 9, wherein a region of the first refractive layer adjoins a region of the light emitting source.
